# EUROPEAN PATENT APPLICATION

(11) **EP 4 565 028 A1**
(43) Date of publication of application: **04.06.2025**
(21) Application number: 24212946.8
(22) Date of filing: 14.11.2024
(51) Int. Cl.: H10D 30/66, H10D 30/01, H10D 64/27, H10D 64/20

(54) **TRENCH-GATE ELECTRONIC DEVICE WITH BURIED SOURCE FIELD PLATE, AND MANUFACTURING METHOD THEREOF**

(30) Priority: 01.12.2023 IT 202300025728
(71) Applicant: STMicroelectronics International N.V., 1228 Plan-les-Ouates, Geneva (CH)
(72) Inventor: ENEA, Vincenzo, 96100 SIRACUSA (IT)
(74) Representative: Studio Torta S.p.A.

(57) **Abstract**

The disclosure relates to the formation of a variable trench dimension area, including a plurality of trenches extending in a strip-like fashion in top-plan view. A bigger trench hosts both the source poly field plate contact and the poly gate region. All of the trenches are spaced apart from one another by a constant quantity, to maintain the expected field plate effect and avoid impact on breakdown voltage. To recover the resulting bigger pitch dimension, the trenches around the bigger one are formed with smaller and decreasing dimension from the inner to the outer one. The sum of the pitch of these cells will result equivalent to the sum of the pitch of the same numbers of standard cells. In this way the impact on electrical performances and efficiency is limited or even avoided.

## Description

### TECHNICAL FIELD

The present invention relates to a trench-gate electronic device (in particular a trench-gate power MOSFET), and manufacturing method thereof.

### BACKGROUND ART

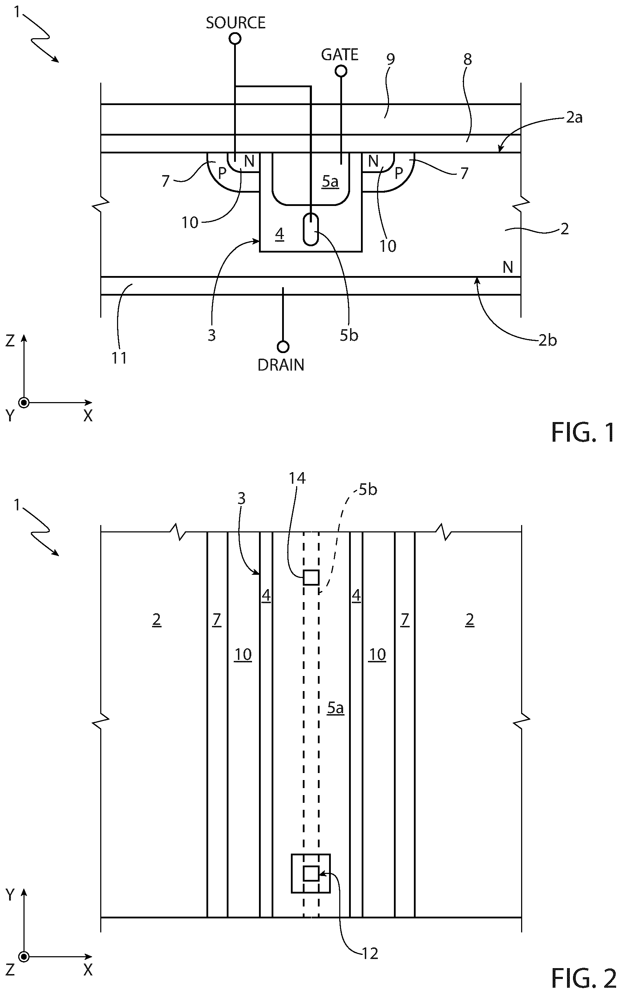

Reference is made to Figure 1, where a power MOS transistor 1 according to the art is shown in lateral cross section (figure 1 is a simplified view of the MOS transistor, where element not useful for the understanding of the present disclosure are not illustrated and described). Figure 1 is represented in a triaxial reference system of three axis X, Y, Z orthogonal to one another.

The power MOS transistor 1 comprises: a semiconductor substrate 2 having a first and a second side 2a, 2b, opposite to one another along the direction of the axis Z, and a first type of conductivity (N); a trench 3 in the semiconductor substrate 2 at the first side 2a; an oxide region 4 extending at bottom and lateral walls of the trench 3; a conductive gate region 5a in the trench 3, wherein the the oxide region 4 extends around the gate region 5a in such a way that the gate region 5a is electrically isolated from the semiconductor substrate 2 by the oxide region 4; a field plate 5b, of electrically conductive material such as N-doped polysilicon, in the trench 3 and buried within the oxide region 4 below the conductive gate region 5a and electrically insulated from the conductive gate region 5a by a portion of the oxide region 4. The buried field plate 5b is formed in the trench 3, below the conductive gate region 5a, in a known way and is used to reduce the electric field in the semiconductor substrate 2 near the trench 3 and to lower parasitic capacitance. Since the field plate 5b is electrically isolated from the conductive gate region 5a, this structure is also known as "shielded-gate" or "split-gate". A top oxide region 28 over the trench 3 and on the conductive gate region 5a is also present. One or more further layers 9 may be present, as apparent to the skilled person. The semiconductor substrate 2 houses, laterally to the trench 3, a first and a second body region 7, having a second type of conductivity (P), facing the first side 2a of the semiconductor substrate 2 and adjacent to opposite (along direction of axis X) lateral sides of the trench 3. A first and a second source region 10 having the first type of conductivity (N) extend within the first and respectively second body region 7 and face the first side 2a. A drain electrode 11 extends at the second side 2b. SOURCE, GATE and DRAIN metal terminals are schematically shown.

During device switch-off operation, when drain current passes from its maximum value to about zero, the rise of the drain voltage causes power losses. Any reduction of the rising curve of this voltage would produce higher power dissipation and lower efficiency. An issue than can slow down drain voltage rise during switch-off is the dynamic grounding of poly field plate. A grounding delay can cause a temporary BVdss (drain to source breakdown voltage) at low voltage, which in turn cause a voltage rise clamp and current conduction until the whole poly field plate grounding is achieved.

Polysilicon field plate 5b is connected to ground voltage by means of one or more contacts 12 (shown in Figure 2) coupled with the metal source terminal. The contacts 12 of the filed plate 5b are formed by etching the semiconductor substrate 2 at the first side 2a until the filed plate 5b is reached. To form these contacts 12, the conductive gate region 5a is locally interrupted to avoid gate leakage current (Igss) issues and provide adequate space for the filed plate contact itself.

As known, in a top-plan view on XY plane, the gate region 5a, the field plate 5b, the body region 7 and the source region 10 extend in a strip-like fashion, for example with main direction of extension along the Y axis, as represented in Figure 2. The contact 12 of the field plate 5b is formed on one side (along axis Y) of the field plate strip, while on the opposite side a contact 14 of the conductive gate region 5a is formed. This solution determines, during switching operations, a polarization of the field plate 5b, which starts from one side of the field plate 5b strip (where the contact 12 is actually present) and with a time delay reaches the opposite side (along axis Y) of the field plate 5b strip (where no contacts 12 are present). It can be understood that the dynamic polarization of the field plate 5b can become weaker as the dimension along axis Y of the field plate 5b strip increases. In these conditions the time delay for full polarization becomes sensible to the physical and geometrical characteristics of the MOS transistor 1.

To minimize the dynamic polarization time of the field plate 5b, one solution that can be adopted (and which is not necessarily prior art) is to reduce as much as possible the resistivity of the field plate 5b by properly designing the N-type doping level of the polysilicon of the field plate 5b (i.e., increasing the doping level) and/or by increasing the dimensions and depth of the trench 3, which in turn allows to form a larger and deeper poly field plate 5b. However, the above possible solutions are limited from a manufacturing process perspective, because poly doping cannot be increased behind the physical limits and behind the technical possibilities offered by the manufacturing tools used in production plants, and from a design/functionalities perspective because a larger and deeper trench 3 has a negative impact on technology performances and efficiency of the MOS transistor 1.

Patent application US2022/320332A1 generally relate to metal oxide semiconductor field effect transistor (MOSFET) devices and, in particular, to a gate contact structure for a trench-type power MOSFET having a split gate configuration including a pair of polysilicon gate lobes laterally separated by a polyoxide region and electrically coupled by a polysilicon gate bridge.

Patent application CN111969051A belongs to the field of power semiconductors, and in particular relates to a split-gate VDMOS device with high reliability and a manufacturing method thereof, including a cell area, a transition area and a terminal area.

However, the above-mentioned issues are not solved.

The object of the present invention is to provide an electronic device and a method for manufacturing the electronic device, to overcome the disadvantages of the known art.

### SUMMARY OF INVENTION

According to the present invention an electronic device and a method for manufacturing the electronic device are provided, as defined in the appended claims.

### BRIEF DESCRIPTION OF THE DRAWINGS

For a better understanding of the present invention, preferred embodiments of it will now be described, purely by way of a non-limiting example, with reference to the appended drawings, in which:
- Figure 1 shows, in a lateral cross-sectional view, a MOS transistor according to the known art;
- Figure 2 shows, in a top view, the MOS transistor of Figure 1;
- Figures 3 and 4 illustrate a corresponding top-plan view of a same portion of an electronic device, according to an aspect of the present invention;
- Figure 5A illustrates a cross-section view of the electronic device of Figure 4, along cut line V-V of Figure 4;
- Figure 5B illustrates a prospective view of the electronic device of Figure 5A, with the section of figure 5A is visible;
- Figure 6A illustrates a cross-section view of the electronic device of Figure 4, along cut line VI-VI of Figure 4;
- Figure 6B illustrates a prospective view of the electronic device of Figure 6A, with the section of figure 6A is visible;
- Figure 7 illustrates the electronic device of the present invention in the same view of Figure 3, according to a further embodiment;
- Figure 8 illustrates a cross-section view of the electronic device of the present invention, according to a further embodiment; and
- Figures 9A-9M illustrate steps of a method of manufacturing the electronic device of the present invention.

### DETAILED DESCRIPTION OF THE INVENTION

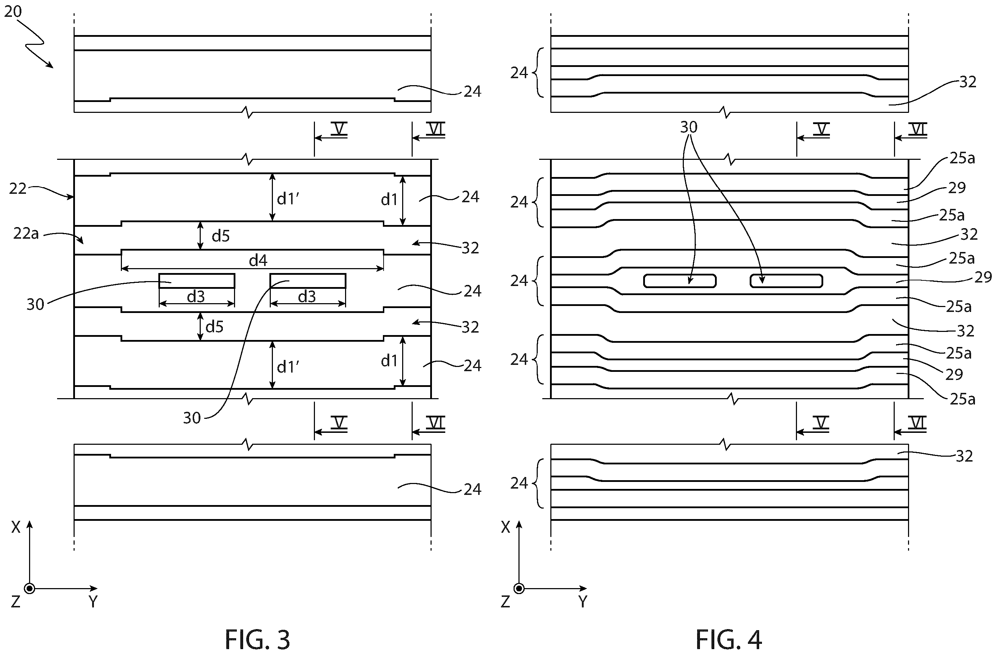

Figure 3 shows, in the same reference system of axis X, Y, Z of Figure 2, a top-plan view (on plane XY) of a portion of an electronic device 20 according to an embodiment of the present invention. In Figure 3, the shape (by design) of the trenches 24 is shown from the top.

Figure 4 shows, in the same reference system of axis X, Y, Z of Figure 3, the same top-plan view (on plane XY) of the same portion of the electronic device 20 of Figure 3. In Figure 4, gate conductive regions and source field plate contacts are shown.

The electronic device 20 is for example a MOS transistor.

With reference to figures 3 and 4, the electronic device 20 comprises a semiconductor body 22 (including a substrate and optionally one or more epitaxial layers, as needed) having a top side 22a opposed to a bottom side 22b along the Z axis. The semiconductor body 22 has a first conductivity type, for example N-type doping. For example, the semiconductor material is Silicon or SiC, with a doping concentration for example between 1·10¹⁶ and 5·10¹⁶ atoms/cm³.

At the top side 22a, a plurality of trenches 24 are formed, for example by etching the semiconductor body 22 by means of standard lithographic techniques or LASER drilling or still other techniques. The trenches extend from the top side 22a towards the bottom side 22b, ending within the semiconductor body 22.

Each one of the trenches 24 houses, in one embodiment, two conductive gate regions 25a. Below the conductive gate regions 25a, a source field plate 25b extends, analogously to the source field plate 5b of Figure 1. An insulating filling region 26 (for example, of SiO₂ or of another electrically-insulating material) extends in each trench 24 around the conductive gate regions 25a, thus electrically insulating the conductive gate regions 25a from the semiconductor body 22 and from the source field plate 25b. The source field plate 25b is buried within the insulating filling region 26.

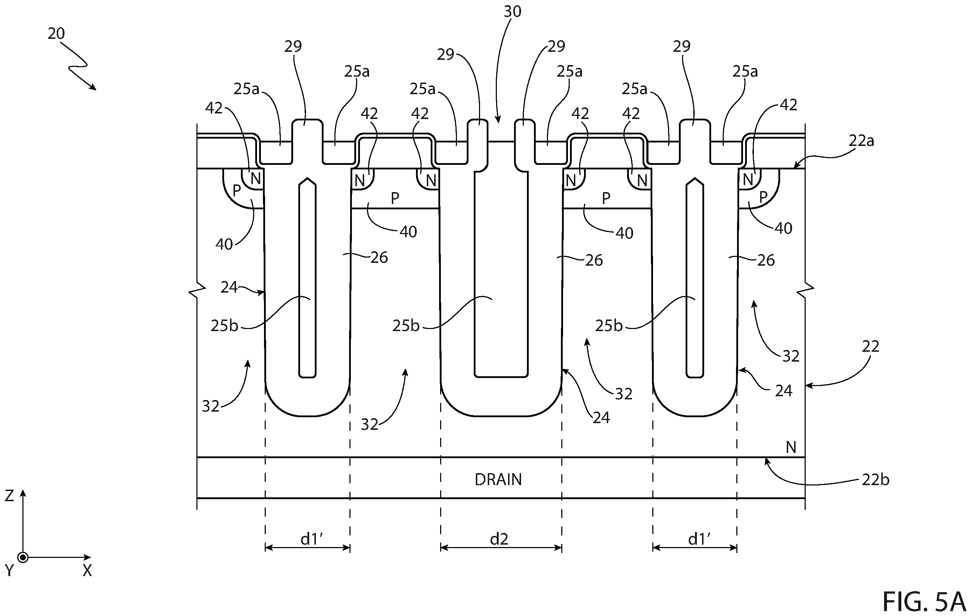

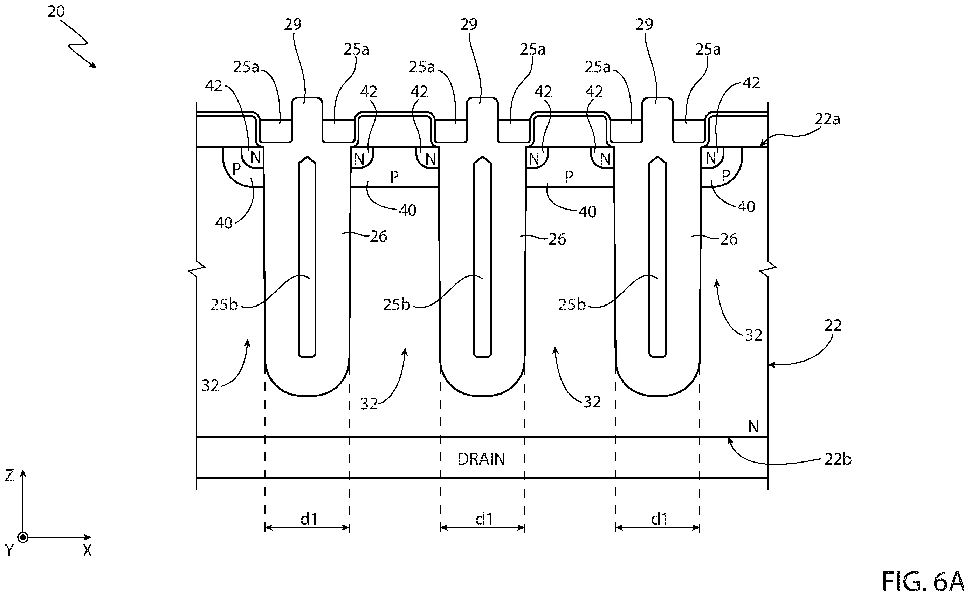

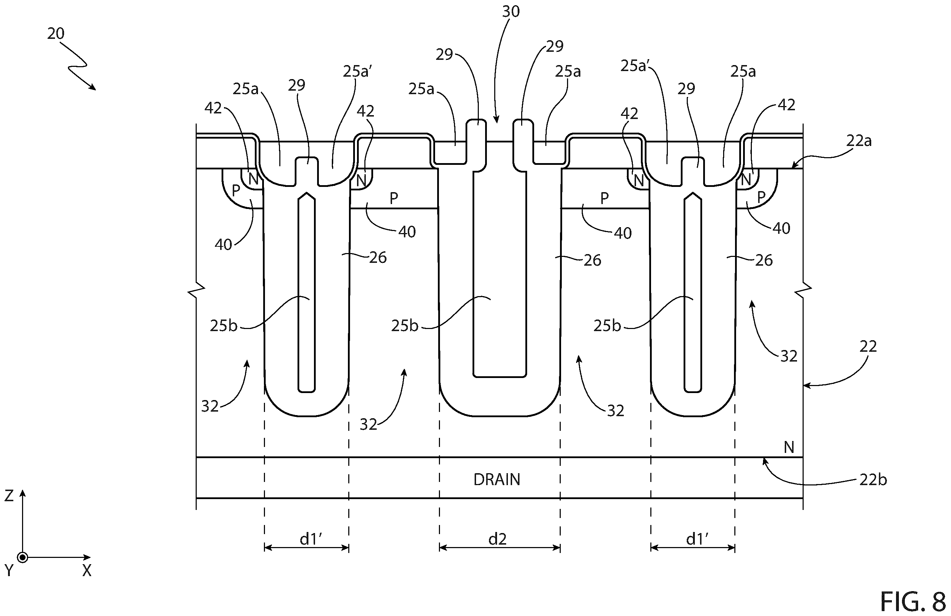

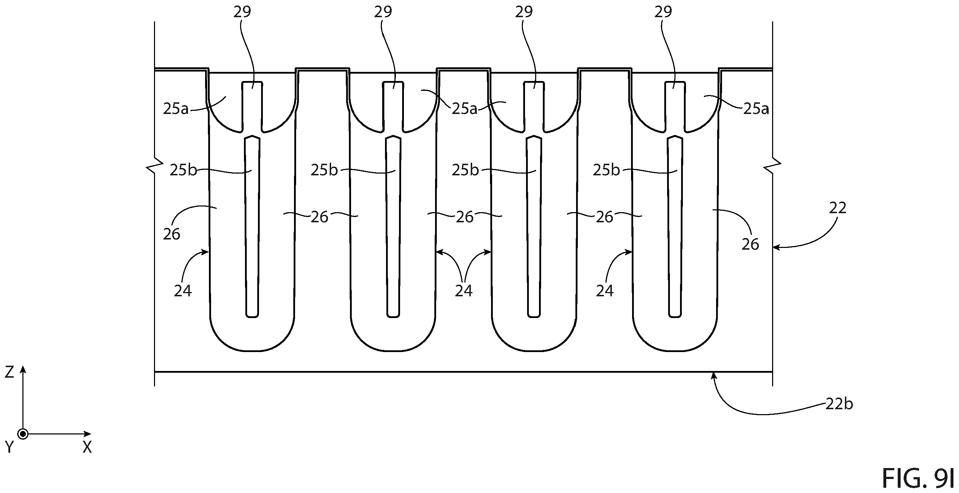

In some embodiments, an elongated element 29 (also named as "protrusion" 29 in the following) of insulating material (e.g., oxide, such as SiO₂) is present above each source field plate 25b and vertically aligned with the source field plate 25b in each trench. The protrusion 29 may extend along the Z direction to a height that is above that of the top side 22a and/or above the maximum height of the conductive gate regions 25a (see for example figures 5A and 6A). However, in other embodiments, the protrusion 29 may extend along the Z direction to a height that is the same or lower than that of the top side 22a and/or lower than the maximum height of conductive gate regions 25a (see for example Figure 8 or figures 9I-9G).

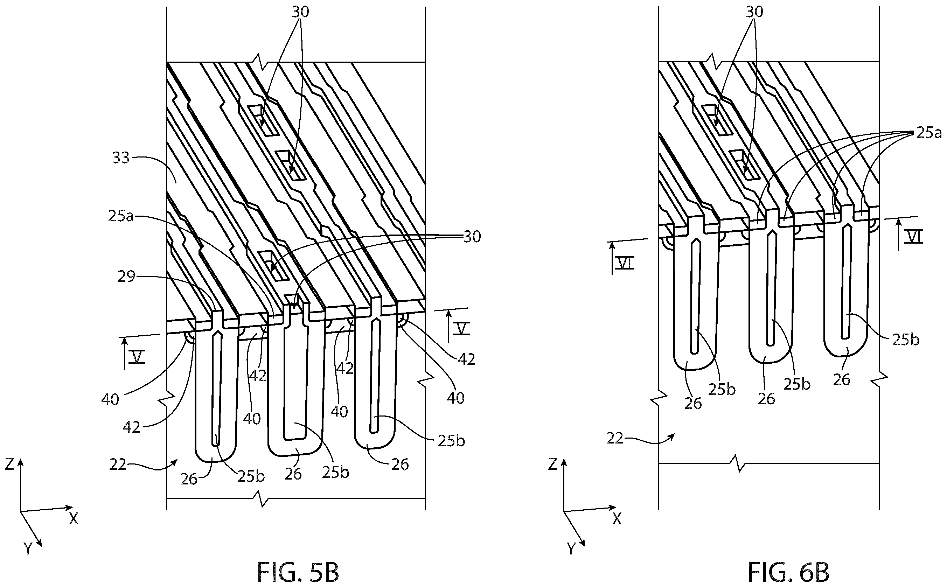

In the embodiment of figures 5A, 5B, 6A, 6B, in each trench 24 the protrusions 29 physically and electrically separate the two conductive gate regions 25a. As better shown in figures 5A and 5B, the protrusions 29 accommodate, or contain, contact openings 30 configured to provide a local electrical access to the source field plate 25b. In particular, to achieve the electrical contact, the source field plate 25b locally reaches the top side 22a or it is even above the top side 22a at the regions where the contact openings 30 are present. At least one opening 30 is formed in correspondence of each trench 24, surrounded by the protrusion 29, so that the source field plate 25 is exposed, to be later contacted by a conductive (e.g. metal) material. The contact openings 30 and the respective conductive contacts (not shown) are electrically insulated from the conductive gate regions 25a by lateral walls of the protrusions 29. The electrical continuity of the conductive gate region 25a is in any case guaranteed laterally to the protrusions 29, as shown by the continuous gate strips 25a in Figure 4. Where the contacts 30 are to be formed, the trench 24 and, correspondingly, the source field plate 25b are locally enlarged; moreover, the source field plate 25b is not recessed, and locally reaches the level of the top side 22a or a level above the surface 22, to ease the formation of the electrical contact. The conductive gate regions 25b bend to externally follow / copy the shape of the locally-enlarged source field plate 25b.

In figures 3 and 4 only one trench 24 is shown with the contact openings 30 and, for facilitating the following description, it is identified with reference numeral 24'. If not otherwise specified, the reference numeral 24 identifies any one or all trenches (and thus also trench 24').

However, it is apparent that each trench 24 houses at least one respective contact opening 30 in the respective insulated protrusion 29, to contact the respective source field plate 25b. It is also apparent that, if a trench 24 does not houses a source field plate 25b, the contact openings 30 are not necessary and therefore they may not be formed.

According to an aspect of the invention, the trench 24' has (in top-plan view) a variable X-axis dimension when considered along its extension along the Y axis. In the following, the term "width" is used to refer to the extension or dimension along the X axis; the term "length" is used to refer to the extension or dimension along the Y axis; the term "depth" is used to refer to the extension or dimension along the Z axis.

With reference to Figure 3, the trench 24' has a first width having a first value d1, and a second width having a second value d2. The first value d1 is in correspondence of the region of the trench 24' housing the contact openings 30. The contact openings 30 are completely contained, in top-plan view, within the protrusion 29 of the trench 24' where the trench 24' has the second width value d2. The width of the trench 24' is restricted to the first value d1 before and after (along Y axis) the contact openings 30. The protrusion 29 has a corresponding variable width, being wider (along X axis) where the trench has the dimension d2 and stricter (along X axis) where the trench has the dimension d1.

In one example, as shown in figures 3 and 4, the enlarged trench region having width d2 houses two contact openings 30 aligned along a same direction parallel to the Y axis and physically separated from one another. In this case, the enlarged trench region having width d2 has a length d4 higher than 2·d3. The two contact openings 30 are spaced apart from one another, along the Y axis direction, for example of a quantity d3/2.

In another example, not shown, only one contact opening 30 is present; the contact opening 30 has a length having value d3; the length d4 of the enlarged trench region housing such contact opening 30 is d4>d3.

The trenches 24 extend along respective main directions that are parallel to one another and are also parallel to the Y axis. The portion of the semiconductor body 22 between two parallel trenches 24 houses, during use of the electronic device 20, an active area 32, where the conductive channel is formed.

In order not to restrict the active area 32, the two trenches 24 on opposite sides of the trench 24' along the X axis and directly facing the trench 24', in particular at the enlarged portion of the trench 24', are designed to have a variable width that mimics the variable width of the trench 24'. More in particular, the trenches 24, directly facing the trench 24' on both sides (opposite to one another along the X axis) of the trench 24', are designed in such a way that the portion of the active area 32 comprised therebetween has a constant area / constant volume value. The distance between directly facing trenches 24 is identified in the drawings as d5.

In one example, the trenches 24 arranged laterally to the trench 24' (along X direction)have a width that is equal to d1 where the trench 24' has the width d1, and equal to d1' where the trench 24 has the width d2. The value of d1' is equal to or lower than the value of d1. In one embodiment, the value of d1' is between 89% and 100% of the value of d1.

In one exemplary embodiment:
d1 is in the range 1.30-1.40 µm, in particular 1.36 µm;
d1' is in the range 1.25-1.40 µm, in particular 1.27 pm;
d2 is in the range 1.60-2 µm, in particular 1.70 pm;
d3 is in the range 1-2 µm, in particular 1.60 pm;
d5 is in the range 0.6-1 µm, in particular 0.74 µm.

Figure 5A illustrates a cross-sectional view of the electronic device 20 of figures 3 and 4, along the cut line V-V shown in figures 3 and 4. It can be seen that trench 24' is larger (along X axis) than trenches 24 extending laterally to trench 24'. The protrusion 29 is correspondingly larger. The active area 32 between anyone trenches 24 is not impacted, in terms of dimensions along the X axis, by the enlarged portion of the trench 24', due to the corresponding "shift" of the trenches 24 arranged laterally to the trench 24'. In the active area region 32, laterally to each trench 24, 24', body regions 40 and source regions 42 are present, similarly to what is shown in Figure 1 and described with reference to it.

A drain terminal is present at the bottom side 22b of the semiconductor body 22.

Figure 5B shows a prospective view of the embodiment of figures 4 and 5A, truncated along a plane XZ, to appreciate the section corresponding to that of Figure 5A.

Figure 6A illustrates a cross-sectional view of the electronic device 20 of figures 3 and 4, along the cut line VI-VI shown in figures 3 and 4. It can be seen that trench 24' has, in this section, the same width as trenches 24 extending laterally to trench 24'. The active area 32 between anyone of trenches 24, 24' has constant width (in top-plan view) for the entire extension of the Y axis.

In the active area region 32, laterally to each trench 24, 24', body regions 40 and source regions 42 are present, similarly to what is shown in Figure 1 and described with reference to it.

A drain terminal is present at the bottom side 22b of the semiconductor body 22.

Figure 6B shows a prospective view of the embodiment of figures 4 and 6A, truncated along a plane XZ, to appreciate the section corresponding to that of Figure 6A.

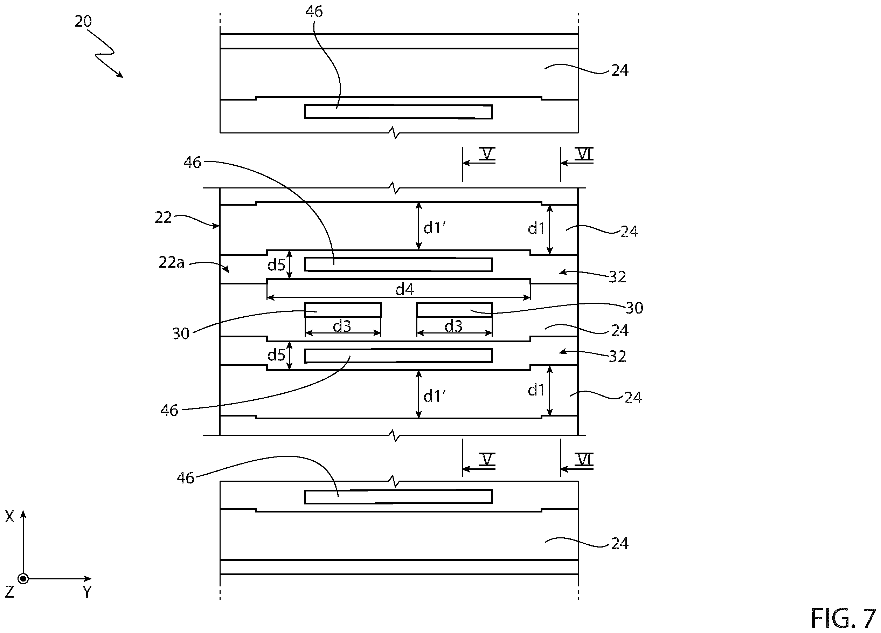

Figure 7, which is based on the representation of Figure 3, shows a further embodiment where contacts are introduced in the active area 32, to electrically contact the body regions 40 and the semiconductor body 22 below the body regions 40 to reduce the negative effects deriving from the parasitic body-drain diode. Such contacts are formed by forming further contact openings 46 in the semiconductor body 22, between trenches 24.

As described above, in each trench 24, 24', there are two conductive gate regions 25a, which extend, in top-plan view, laterally to the source field plate 25b buried in the same trench 24, 24'. The two conductive gate regions 25a are physically separated from one another by the protrusion 29. However, in an alternative embodiment, the two conductive gate regions 25a in each trench can be physically and electrically connected to one another by a contact portion 25a' passing over the protrusion 29. More specifically, in the embodiment of Figure 8, the protrusion 29 is recessed (below the silicon surface) where the contact openings 30 are absent. Where the contact openings 30 are present, the protrusion 29 protrudes from the top side 22a of the semiconductor body 22, thus generating a local bifurcation of the conductive gate region 25a, which locally takes the shape of the embodiment of Figure 4. The bifurcated conductive gate region 25a comprises two gate strips joined together at opposite sides along the Y axis direction. The bifurcated conductive gate regions 25a house one or more contact openings 30 therebetween and between the opposite sides that are joined together. The protrusion 29 and the contact opening(s) 30 formed at the protrusion 29 form a connection island or connection point for electrically contacting the source field plate 25b without electrically contacting the conductive gate region 25a in the same trench 24, 24' .

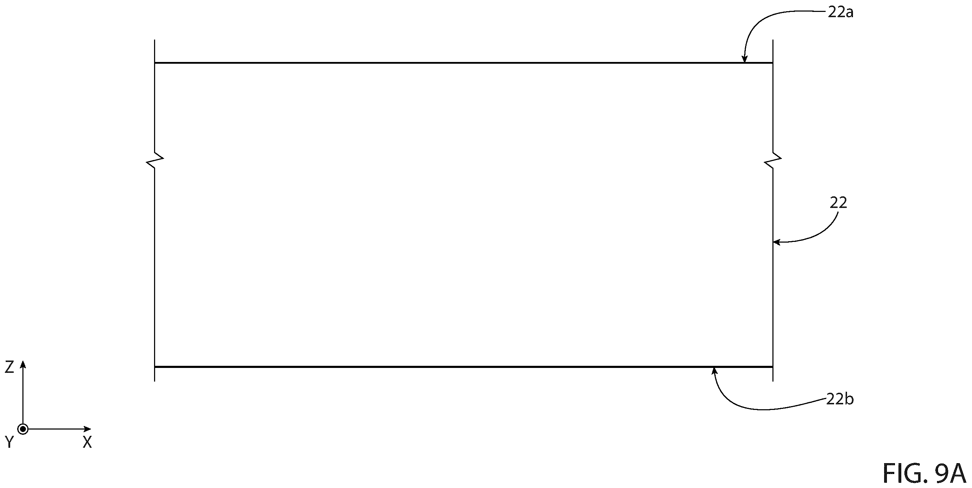

Figures 9A-9M illustrates a method for manufacturing the electronic device 20, with specific reference to the embodiment of Figure 8. However, the steps disclosed are applicable, as immediately apparent to the skilled person, to manufacture the electronic device 20 according to anyone of the other disclosed embodiments.

In Figure 9A, a semiconductor substrate is provided, over which an optional epitaxial layer is grown. The substrate and the epitaxial layer form, together, the semiconductor body 22. The substrate and the epitaxial layer are for example of Silicon having an N-type doping.

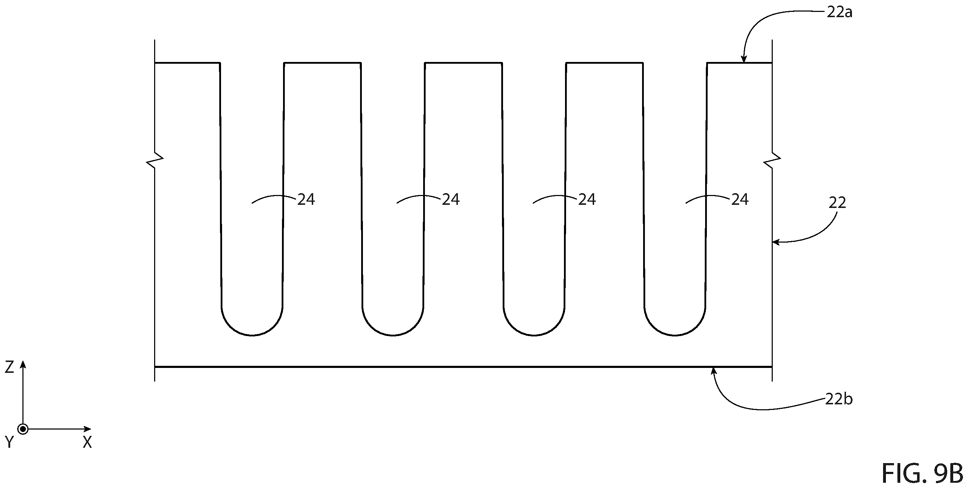

Then, Figure 9B, trenches 24 are formed by etching the semiconductor body 22 from the top side 22a. the etching is performed by known techniques, such as RIE (reactive ion etching) or DRIE (deep reactive ion etching). In the drawings, the trenches 24 have vertical sidewalls; according to the process used for manufacturing the trenches, they may also have inclined sidewalls, such as a truncated V-like shape in a side view, or a truncated reversed-pyramid shape. The teaching of the present invention applies analogously also in case of sidewalls of the trenches 24 not perfectly parallel to the Z axis.

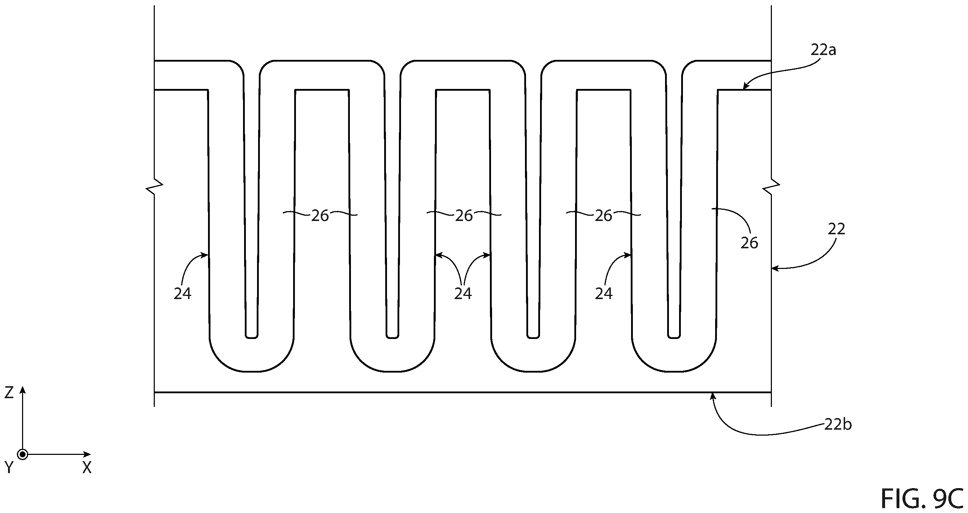

Then, Figure 9C, the trenches 24 are partially filled with electrical insulating material, forming the insulating filling region 26. This step is performed, for example, by growing or depositing silicon oxide (SiO₂) in case the semiconductor body 22 is of Silicon; another insulating material can be grown or deposited based on the material of the semiconductor body 22.

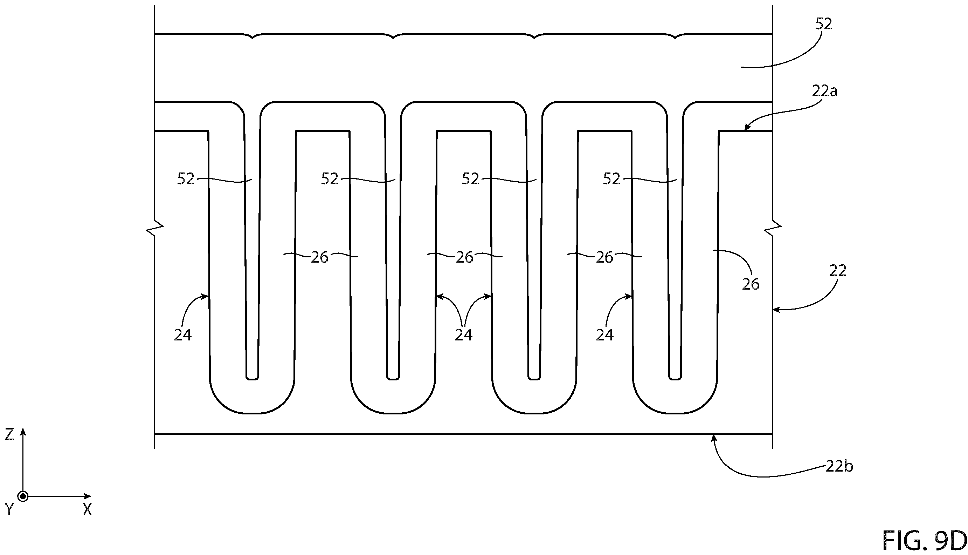

Then, Figure 9D, a step of filling the trenches 24 with conductive material is carried out, forming a conductive region 52 in the trenches 24 and on the semiconductor body 22. The conductive material is for example N-doped polysilicon and completely fills the trenches 24.

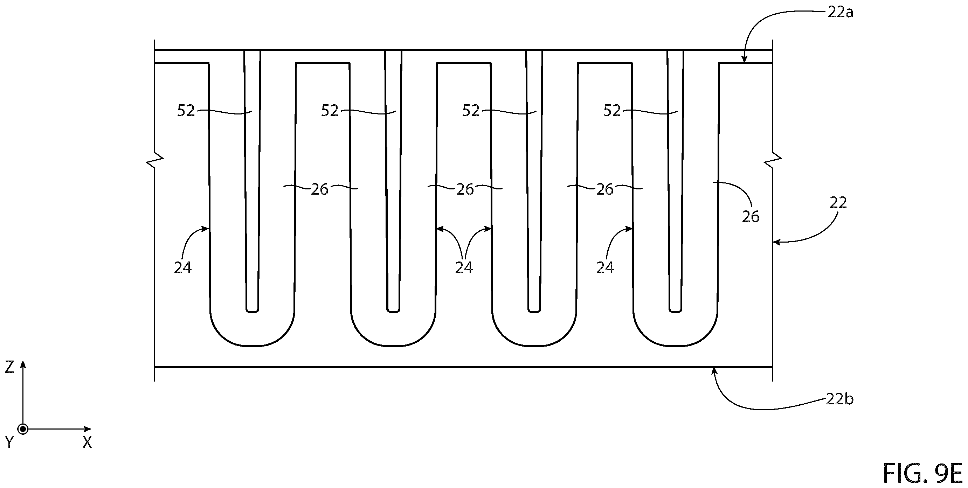

Then, Figure 9E, a step is carried out to remove selective portions of the conductive region 52 over the top side 22a of the semiconductor body 22, preserving the conductive region 52 within the trenches 24. This step can be carried out by means of a CMP technique (chemical-mechanical polishing).

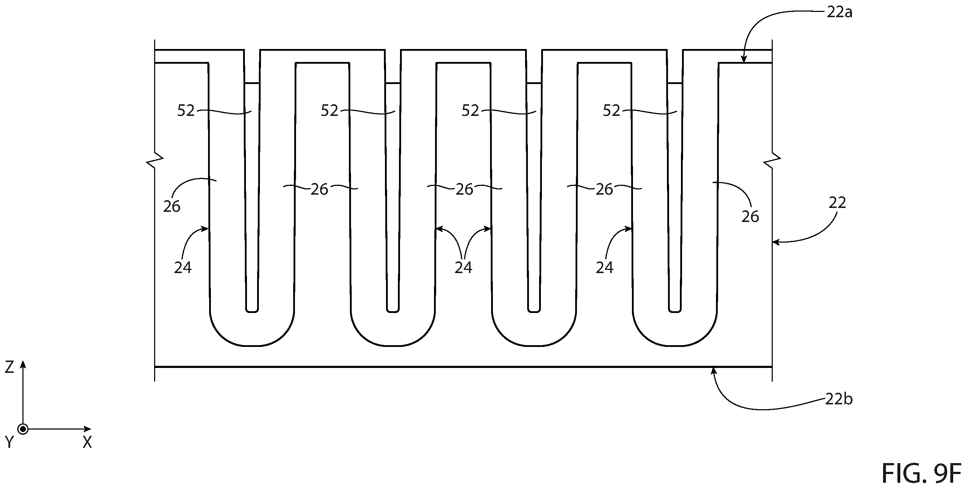

Then, Figure 9F, a step is carried out to partially etch the conductive region 52 within the trenches 24. The conductive region 52 is thus recessed in each trench 24 until the conductive region 52 is below, or coplanar with, the top side 22a.

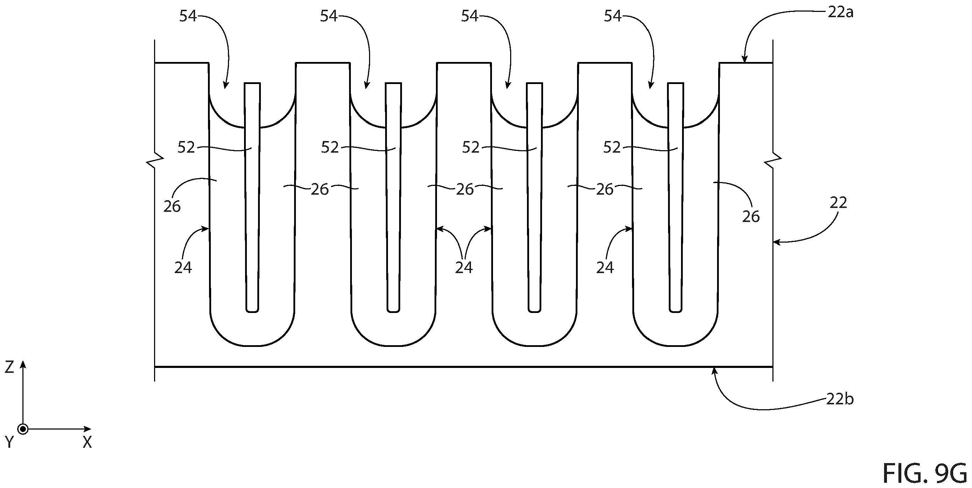

Then, Figure 9G, the insulating filling region 26is partially etched in correspondence of the top side 22a, to form a recess 54 in each trench. The etching is selective against the material of the insulating filling region 26 and preserves the material of the conductive region 52 in the trenches; the etching removes the insulating material until the conductive region 52 protrudes from the insulating filling region 26.

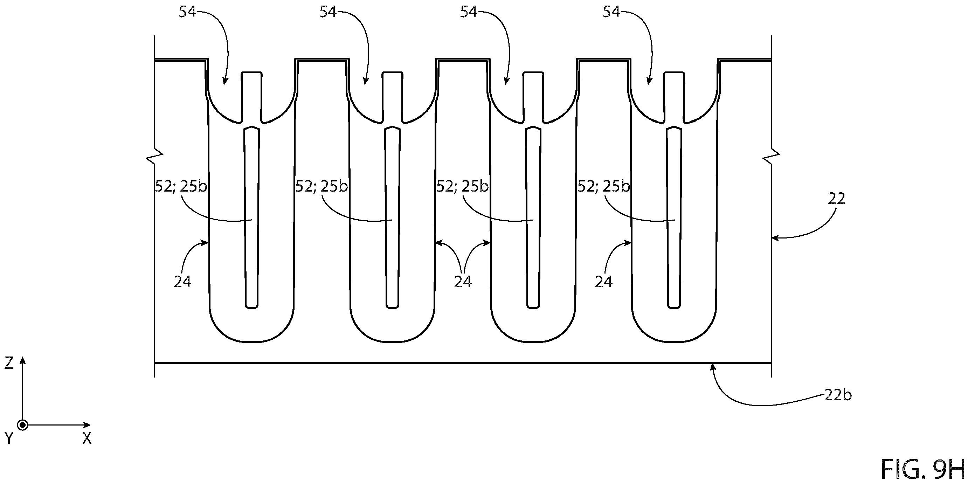

Then, Figure 9H, an oxidation step (for example exposing the wafer to an O₂ environment) is carried out, to oxidize the portion of the conductive region 52 that protrudes from, and is therefore not protected by, the insulating filling region 26 in the trenches 24. This oxidation step is self-limited, and a buried conductive region is formed in the trenches 24. The buried conductive region is the source filed plate 25b previously discussed. The upper portion of the conductive region 52 protruding from the insulating filling region 26 forms, after oxidation, the elongated element 29 ("protrusion" 29) previously discussed. In this embodiment, the protrusion 29 is within the trenches 24 and does not actually protrudes above the top side 22a; however, it is apparent that the protrusion 29 can extend out of the trenches 24 (as in figures 5A and 6A) such that, after oxidation, it actually protrudes to a certain extent from the top side 22a.

Then, Figure 9I, a step of forming the conductive gate regions 25a is carried out. The conductive gate regions 25a are formed by depositing conductive material (e.g., n-doped polysilicon) in the recesses 54. Depending on the shape of the recesses 54 and the form of protrusions 29, the conductive gate regions 25a of the respective embodiments of figures 5A, 6A, 8 are formed.

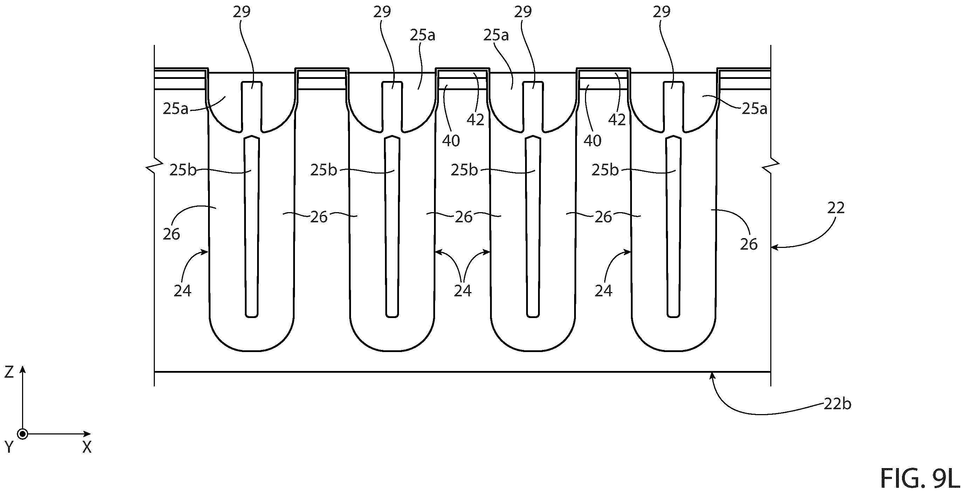

Then, Figure 9L, body regions and source regions 40, 42 are formed by known implants of doping species of P-type and N-type respectively, between the trenches 24.

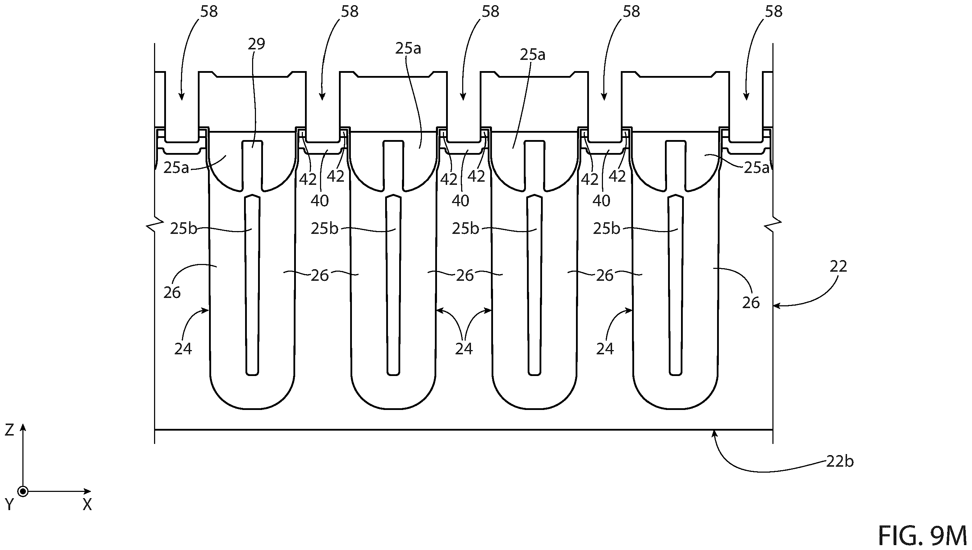

Then, Figure 9M, the semiconductor body 22 is etched between the trenches 24, to form the contact openings 58 providing contacts for a front metal terminal that, in operations, connects the source regions and the body regions to a biasing voltage.

Other steps can be carried out to complete the manufacturing of the electronic device 20, which are not further described because they are not part of the present invention.

The advantages of the present invention are apparent from the present disclosure.

For example, the present invention achieves higher speed on dynamic buried source field plate grounding, and it becomes even a more robust solution for bigger dice, where the grounding is an issue. Low power dissipation during device turn off operations and higher efficiency are also achieved.

Finally, it is clear that modifications and variants may be made to the invention described and illustrated here without thereby going beyond the protective scope of the present invention as defined in the appended claims.

In particular, the present invention can be applied to any type of vertically-conducting device with a trench gate, such as, but not limited to, a VDMOS transistor, or a trench-based power MOSFET device.

## Claims

1. An electronic device (20), comprising:
a semiconductor body (22) having a first and a second side (22a, 22b) opposite to one another along a first axis (Z);
a plurality of trenches (24) extending within the semiconductor body (22) from the first side (22a) towards the second side (22b) and ending within the semiconductor body (22), each one of said trenches (24) having a second direction of extension along a second axis (Y) that is parallel to the top side (22a) and orthogonal to the first axis (Z), and a third direction of extension along a third axis (X) that is parallel to the top side (22a) and orthogonal to the first (Z) and the second (Y) axis;
a gate insulating region (26) in each one of said trenches (24), covering bottom and lateral walls of each one of said trenches (24);
a gate conductive region (25a) in each one of said trenches (24) on the gate insulating region (26), the gate conductive region (25a) being electrically insulated from the semiconductor body (22) by said gate insulating region (26) ;
a source field plate region (25b) in each one of said trenches (24), the source field plate region (25b) being electrically insulated from the gate conductive region (25a) and from the semiconductor body (22) by the gate insulating region (26),
**characterized in that** the electronic device further comprises:
a protrusion (29), of insulating material, protruding from at least a first trench (24') among said plurality of trenches (24),
a passing hole (30) extending through the protrusion (29) towards the source field plate region (25b), reaching the source field plate region (25b); and
a conductive contact within the passing hole (30), electrically coupled to the source field plate region (25b),
wherein:
said first trench (24') has variable dimensions along the third axis (X), including a first dimension (d2) in correspondence of said passing hole (30) and a second dimension (d1) at a distance from said passing hole (30), said distance being along the second axis (Y), the first dimension (d2) being higher than the second dimension (d1);
at least a second trench (24) among said plurality of trenches (24), which extends lateral to the first trench (24') and directly faces the first trench (24'), has respective variable dimensions along the third axis (X), including a third dimension (d1') where the second trench (24) faces portions of the first trench (24') having the first dimension (d2) and the second dimension (d1) where the second trench (24) faces portions of the first trench (24') having the second dimension (d1), the third dimension (d1') being lower than the second dimension (d1); and
the first and the second trenches (24', 24) are spaced apart from one another, at said facing portions, of a constant quantity (d5).

2. The electronic device of claim 1, wherein the gate conductive region (25a) in the first trench (24') extends externally to, or around, the protrusion (29).

3. The electronic device of claim 1 or claim 2, wherein the gate conductive region (25a) is, in each trench (24) of said plurality of trenches (24), electrically continuous along the second axis (Y).

4. The electronic device of anyone of the preceding claims, wherein , a respective protrusion (29) of insulating material protrudes from the second trench (24), the gate conductive region (25a) in the second trench (24) extending externally and laterally to the respective protrusion (29).

5. The electronic device of anyone of the preceding claims, wherein, in the second trench (24), a respective passing hole (30) extends through the respective protrusion (29) towards the source field plate region (25b), reaching the source field plate region (25b), and a respective conductive contact extends within the passing hole (30), electrically coupled to the source field plate region (25b);
said second trench (24) having the first dimension (d2) along the third axis (X) in correspondence of said respective passing hole (30);
said first trench (24') having the third dimension (d1') where the first trench (24') faces portions of the second trench (24) having the first dimension (d2); and
the first and the second trenches (24', 24) being spaced apart from one another, at said facing portions, of said constant quantity (d5).

6. The electronic device of anyone of the preceding claims, wherein plurality of trenches (24) extend, in a top-plan view parallel to the top side (22a), in a strip-like fashion, each trench (24) of said plurality of trenches (24) being spaced apart from an adjacent trench (24) by said constant quantity (d5).

7. The electronic device of claim 6, wherein the adjacent trenches are spaced apart from one another by said constant quantity (d5) for their entire extension along the second axis (Y).

8. The electronic device of anyone of the preceding claims, wherein the semiconductor body (22) is configured to house, during operations of the electronic device (20), a conductive channel along the first axis (Z) between the first and the second trenches (24', 24).

9. The electronic device of anyone of the preceding claims, wherein the semiconductor body (22) has a first conductivity type (N), the electronic device further comprising:
a body region (40) extending at the first side (22a) between the first and the second trenches (24', 24), the body region (40) having a second conductivity type (P) opposite to the first conductivity type (N); and
a source region (42) in the body region (40).

10. The electronic device of anyone of the preceding claims, wherein said conductive contact that extends within the passing hole (30) is electrically insulated from the gate conductive region (25a) by lateral walls of the protrusion (29).

11. The electronic device of anyone of the preceding claims, wherein a further passing hole (30) extends through the protrusion (29) in the first trench (24') towards the source field plate region (25b), reaching the source field plate region (25b),
the passing hole (30) and the further passing hole in the first trench (24') being aligned to one another along the second axis (Y).

12. The electronic device of anyone of the preceding claims, wherein a drain terminal is at the second side (22b) of the semiconductor body (22).

13. The electronic device of anyone of the preceding claims, being of a vertical-conduction type

14. A method of manufacturing an electronic device (20), comprising the steps of:
providing a semiconductor body (22) having a first and a second side (22a, 22b) opposite to one another along a first axis (Z);
forming a plurality of trenches (24)in the within the semiconductor body (22) from the first side (22a) towards the second side (22b) and ending within the semiconductor body (22), each one of said trenches (24) having a second direction of extension along a second axis (Y) that is parallel to the top side (22a) and orthogonal to the first axis (Z), and a third direction of extension along a third axis (X) that is parallel to the top side (22a) and orthogonal to the first (Z) and the second (Y) axis;
forming a gate insulating region (26) in each one of said trenches (24), covering bottom and lateral walls of each one of said trenches (24);
forming a gate conductive region (25a) in each one of said trenches (24) on the gate insulating region (26), the gate conductive region (25a) being electrically insulated from the semiconductor body (22) by said gate insulating region (26);
forming a source field plate region (25b) in each one of said trenches (24), the source field plate region (25b) being electrically insulated from the gate conductive region (25a) and from the semiconductor body (22) by the gate insulating region (26),
**characterized by** further comprising the steps of:
forming, in at least a first trench (24') among said plurality of trenches (24), a protrusion (29) that protrudes above the top side (22a) along the first direction (Z);
forming a passing hole (30) through the protrusion (29) towards the source field plate region (25b), reaching the source field plate region (25b);
forming a conductive contact within the passing hole (30), electrically coupled to the source field plate region (25b) ;
wherein said first trench (24') has variable dimensions along the third axis (X), including a first dimension (d2) in correspondence of said passing hole (30) and a second dimension (d1) at a distance from said passing hole (30), said distance being along the second axis (Y), the first dimension (d2) being higher than the second dimension (d1);
and wherein at least a second trench (24) among said plurality of trenches (24), which extends lateral to the first trench (24') and directly faces the first trench (24'), has respective variable dimensions along the third axis (X), including a third dimension (d1') where the second trench (24) faces portions of the first trench (24') having the first dimension (d2) and the second dimension (d1) where the second trench (24) faces portions of the first trench (24') having the second dimension (d1), the third dimension (d1') being lower than the second dimension (d1); and
the first and the second trenches (24', 24) are formed spaced apart from one another, at said facing portions, of a constant quantity (d5).
